# EUROPÄISCHE PATENTSCHRIFT

(11) **EP 3 524 467 B1**
(45) Veröffentlichungstag und Bekanntmachung des Hinweises auf die Patenterteilung: **15.04.2020**
(21) Anmeldenummer: 19000041.4
(22) Anmeldetag: 23.01.2019
(51) Int. Cl.: B60M 5/00, B61L 23/00, B61L 27/00, G01R 31/00, G01R 31/50

(54) **VERFAHREN UND VORRICHTUNG ZUR ÜBERWACHUNG ELEKTRISCHER LEITUNGEN UND VERBINDUNGEN IN GLEICHRICHTERUNTERWERKEN UND DEN ZUGEHÖRIGEN STRECKENABSCHNITTEN ELEKTRISCHER BAHNEN**
METHOD AND DEVICE FOR MONITORING ELECTRIC LINES AND COMPOUNDS IN RECTIFIER SUB-STATIONS AND THE ASSOCIATED ROUTES OF ELECTRICAL RAILWAYS
PROCÉDÉ ET DISPOSITIF DE SURVEILLANCE DES CONDUCTEURS ÉLECTRIQUES ET DES RACCORDEMENTS DANS DES SOUS-STATIONS À REDRESSEUR ET DES SECTIONS DE ROUTE DES VOIES ÉLECTRIQUES ASSOCIÉES

(30) Priorität: 07.02.2018 DE 102018001112
(43) Veröffentlichungstag der Anmeldung: 14.08.2019
(73) Patentinhaber: Elpro GmbH, 13053 Berlin (DE)
(72) Erfinder: Glugla, Martin, 12489 Berlin (DE); Kahnt, Ulrich, 16348 Wandlitz (DE)

(56) Entgegenhaltungen:
- EP-A1- 1 391 741
- DE-A1-102013 221 138
- ROEHLIG S: "STREUSTROEME BEI DC-BAHNEN UND ELEKTROTECHNISCHE ANFORDERUNGEN AN DEN GLEISBAU STRAY CURRENT AND ELECTROTECHNICAL DEMANDS ON PERMANENT WAY COURANTS VAGABONDS DE LIGNES FERROVIAIRES EN COURANT CONTINU ET EXIGENCES ELECTRIQUES QUI EN DECOULENT POUR LA CONSTRUCTION DE LA VOIE", EB- ELEKTRISCHE BAHNEN, DIV-DEUTSCHER INDUSTRIEVERLAG, Bd. 99, Nr. 1/02, 1. Januar 2001 (2001-01-01), Seiten 84-89, XP001001737, ISSN: 0013-5437
- SCHNEIDER E ET AL: "BAHNRUECKSTROMFUEHRUNG UND ERDUNG BEI BAHNANLAGEN. GLEICHSTROMBAHNEN", EB- ELEKTRISCHE BAHNEN, DIV-DEUTSCHER INDUSTRIEVERLAG, Bd. 96, Nr. 4, 1. April 1998 (1998-04-01), Seiten 99-106, XP000750877, ISSN: 0013-5437
- ALTMANN M ET AL: "SPANNUNGEN UND UEBERSPANNUNGEN IN DER RUECKLEITUNG VON GLEICHSTROMBAHNEN//VOLTAGES AND OVER VOLTAGES IN THE RETURN CIRCUIT OF DC TRACTION SYSTEMS", EB- ELEKTRISCHE BAHNEN, DIV-DEUTSCHER INDUSTRIEVERLAG, Bd. 104, Nr. 3, 1. März 2006 (2006-03-01), Seiten 129-136, XP001540553, ISSN: 0013-5437

## Beschreibung

Bei elektrisch betriebenen Bahnen muss der Strom über einen Rückleiter wieder zurück zur Quelle geführt werden. Dies geschieht über die Fahrschienen und gegebenenfalls spezielle Rückleiterkabel. Dabei entsteht zwischen den Fahrschienen und der Erde eine Potentialdifferenz, die unzulässig hohe Werte erreichen kann. Diese Spannung kann ganz oder teilweise von Personen abgegriffen werden. Zum Schutz vor dieser unzulässig hohen Potentialdifferenz wird die Bahnerdung angewandt. Die Bahnerdung ist eine Erdungsmaßnahme, die im Bereich von elektrisch betriebenen Bahnen angewandt wird. Basis für die Bahnerdung ist die Bahnerde, sie besteht aus den als Fahrstromleiter dienenden Fahrschienen und sämtlichen mit ihnen verbundenen Leitungen, Fahrzeugen und Anlageteilen. Das Hauptelement dabei bilden die Fahrschienen.

Die Bauwerkserdung wird als Erdung bei Gebäuden für Unterwerke, Tunneln oder sonstigen Kunstbauten angewandt. Hier werden alle elektrisch leitfähigen Metallteile wie z.B. Bewehrungen, Metallkonstruktionen von Tunneln oder Stützmauern und anderen Gebäuden im Bereich der Bahntrasse miteinander elektrisch leitend verbunden. Diese Bauwerkserdung bildet ein von der Bahnerde und der Erde des öffentlichen Netzes galvanisch getrenntes System. Bei Auftreten einer unzulässig hohen Potentialdifferenz erfolgt die zeitweise Verbindung der Erdungssysteme durch Spannungsdurchschlagsicherungen oder automatische Erdungskurzschließer, die die Bauwerkserde mit der Bahnerde im Bedarfsfall für die Dauer der Gefährdung vorübergehend leitend miteinander verbinden.

Bei Gleichstrombahnen kann es zu Streuströmen im Erdreich kommen. Dadurch bedingt werden Rohrleitungen oder andere metallische Bauteile, die im Erdreich verlegt sind, durch Korrosion zerstört. Außerdem besteht die Gefahr, dass Kabel thermisch überlastet werden.

Um das Verschleppen des Bahnpotentials zu vermeiden, gibt es unterschiedliche Lösungsansätze.

Eine Lösung dieses Problems wird in der DE 102 36 943 A1 beschrieben. Sie betrifft ein Verfahren zum Erkennen von Gefährdungen durch Streuströme, die bei einer Bahnstrecke mit Gleichstromversorgung von der den Fahrstrom rückleitenden Fahrschiene zur Erde gelangen. Nach einer ersten Ausführung, bei der die Spannung zwischen Fahrschiene und Erde gemessen wird und bei Abweichen von einem Spannungsreferenzwert eine erhöhte Gefährdung durch Streuströme angezeigt wird, ist vorgesehen, dass die Spannung an mehreren Messstellen entlang der Bahnstrecke gemessen wird und dass die Messwerte in einer Auswertezentrale ausgewertet werden. Nach einer zweiten Ausführung ist vorgesehen, dass durch Aktivieren eines Kurzschließers ein Parallelweg zur Fahrschiene zum Rückleiten des Fahrstromes eingeschaltet wird. Die Stromstärke im Parallelweg wird dann gemessen und beim Abweichen von einem Stromstärkereferenzwert wird eine erhöhte Gefährdung durch Streuströme angezeigt. Besonders die gemeinsame Auswertung von mehreren Messwerten, die entlang der Bahnstrecke ermittelt wurden, ist für das Verfahren wichtig.

In der DE 43 32 888 A1 wird ein Verfahren zur Ermittlung und Meldung des elektrischen Zustands von Spannungsdurchschlagsicherungen sowie eine Anordnung zur Durchführung des Verfahrens beschrieben. Bei Gleichstrombahnen werden üblicherweise die Fahrschienen zum Leiten des Stromes benutzt. Zur Verringerung der Streustrom-Korrosionsgefahr dürfen die Gleisanlagen nicht mit Anlagen, Bauteilen oder Bauwerken mit Erderwirkung leitend verbunden werden. Somit wird das Schienenpotential der Gleisanlage, als Bahnerde bezeichnet, isoliert vom allgemeinen Erdpotential, der sogenannten Wassererde, betrieben. Dadurch können erhebliche Potentialunterschiede zwischen Bahnerde und Wassererde auftreten. Überschreiten diese Potential Differenzen einen bestimmten Wert, werden sie für Menschen zu einer Gefahr, insbesondere an solchen Stellen, wo durch die räumliche Nähe der potential führenden Teile die Möglichkeit der Überbrückung durch den Körper besteht. Das trifft insbesondere für solche Stellen zu, wo sich z. B. Brückenteile oder Schienen einer Wechselstrombahn in der Nähe der Gleise einer Gleichstrombahn befinden. An solchen Stellen ist aus Gründen des Schutzes gegen gefährliche Körperströme eine zumindest zeitweise leitende Verbindung zwischen der Bahnerde und der Wassererde, für die Dauer der Gefährdung herzustellen. Üblicherweise werden zwischen solchen, unterschiedliches Potential führenden, Teilen Spannungsdurchschlagsicherungen eingesetzt. Bei Überschreiten einer vorgegebenen Potentialdifferenz zwischen den Erdungssystemen, die einen gefährlichen Körperstrom verursachen kann, sprechen die Spannungsdurchschlagsicherungen an und stellen eine metallische, elektrisch leitende Verbindung zwischen der Fahrschiene der Gleichstrombahn (Bahnerde) und der Fahrschiene einer Wechselstrombahn bzw. Brückenteilen (Wassererde) her. Dieser Zustand, der nun seinerseits die Streustrom-Korrosionsgefahr erheblich begünstigt, darf nach bestehenden Vorschriften nur kurzzeitig aufrechterhalten werden. Dabei wird an den vorhandenen Spannungsdurchschlagsicherungen, die entlang der Strecke einer Gleichstrombahn angeordnet sind, die Potentialdifferenz zwischen Schienenpotential (Bahnerde) und dem Erdpotential (Wassererde) erfasst und dieser Zustand zu wird zu festgelegten Zeitpunkten oder in definierten Zeitintervallen mit der zugehörigen Adresse in geeigneter Weise einer Zentrale übermittelt werden, wo eine Auswertung der Zustände der einzelnen Spannungsdurchschlagsicherungen erfolgt und unverzüglich geeignete Maßnahmen zur Beseitigung von erkannten Fehlern eingeleitet werden können.

In der DE 10 2013 221 138 A1 wird ein Verfahren zur Überwachung eines Rückleiterkabels vorgestellt. Für einen sicheren Bahnbetrieb mit elektrisch betriebenen Schienenfahrzeugen ist die Verlegung von Rückleiterkabeln parallel zu den Schienen eines Bahngleises unabdingbar. Bei dem Verfahren zur Überwachung eines Rückleiterkabels eines Bahngleises, insbesondere zur Erfassung einer Unterbrechung des Rückleiterkabels in Folge eines Kabelbruchs oder Kabeldiebstahls, werden die in den Schienen des Bahngleises und im Rückleiterkabel fließenden Rückströme des Betriebsstromes erfasst und die Summe der Rückströme in den Schienen mit dem Rückstrom im Rückleiterkabel verglichen. Bei einer oberhalb eines vorgegebenen Schwellwertes liegenden Abweichung der Summe der Rückströme in den Schienen von dem Rückstrom im Rückleiterkabel wird ein Signal ausgelöst.

Da somit bei Rückleiterkabeln pro laufenden Meter eine Masse bzw. ein Gewicht von vier bis fünf Kilogramm hochwertigen Kupfers anfällt, sind insbesondere Rückleiterkabel in Bahnanlagen ein begehrtes Ziel von Kabeldiebstählen. Derartige Diebstähle bedeuten jedoch nicht nur einen Verlust hochwertigen Kupfers, sondern führen insbesondere zu Unterbrechungen im Bahnbetrieb und aufwendigen Reparaturarbeiten, so dass durch Kabeldiebstähle Schäden verursacht werden, die ein Mehrfaches des Materialwertes des Kupfers der Rückleiterkabel betragen.

Die DD 278 994 A1 beschreibt eine Rückleiterkabel-Überwachung für Gleichstrombahnen. Sie beinhaltet die Überwachung von Rückleiterkabeln in Gleichstrom-Bahnunterwerken. Der Erfindung liegt die Aufgabe zugrunde, eine Rückleiterkabel-Überwachung in Gleichrichterunterwerken zu entwickeln, die ein wesentlich genaueres Auslösekriterium im Vergleich zu bisher bekannten Lösungen durch das Erfassen und Verarbeiten von aussagefähigen Messgrößen liefert. Erfindungsgemäß wird das dadurch erreicht, dass ein Summenrückstrom direkt zwischen der Rückleiter-Klemme des Gleichrichterunterwerks und der Rückleiter-Sammelschiene erfasst und mit einem im Vergleich zum Summenrückstrom schwachen, aus einem Hilfszweig mit einem Widerstand zwischen der Stationserdklemme und der Rückleiter-Klemme des Gleichrichterunterwerks gewonnenen, Nebenstrom verglichen wird und der Vergleichswert in bekannter Weise einem die Auslösung vornehmenden Schwellwertschalter zugeführt wird.

In der DE 197 53 048 A1 wird ein Verfahren und eine Vorrichtung zur Kontaktüberwachung mittels Potentialerfassung beschrieben. Das Verfahren ist dadurch gekennzeichnet, dass der Potentialverlauf von leitfähigen Einrichtungen im elektrisch verbundenen Zustand für einen bestimmten Zeitraum ermittelt wird und in einen Kennwert umgewandelt wird, mit dem in gleicher Weise ermittelten Kennwert im offenen Zustand laufend verglichen wird. Der Potentialverlauf unterscheidet sich wesentlich für die Fälle verbunden und nicht verbunden. Der Potentialverlauf für einen der beiden Fälle, in der Regel der der verbundenen Einrichtungen, wird über einen definierten Zeitraum erfasst, gespeichert und über einen mathematischen Algorithmus in eine signifikante Kenngröße umgewandelt. Nach diesem Zeitraum wird der jeweils andere Fall (Normalzustand) hergestellt und die Kenngröße laufend mit der des gespeicherten Falles verglichen. Bei Auftreten des dem geschlossenen Zustand ähnlichen Kennwertes wird ein zur Weiterverarbeitung geeignetes elektrisches Signal zur Verfügung gestellt. Damit erfolgt eine Zustandsüberwachung von leitfähigen Einrichtungen und zwischen beliebigen leitfähigen Einrichtungen befindlicher Kontakte oder Sicherungen.

Alle bekannten Verfahren und/oder Vorrichtungen weisen den Nachteil auf, dass keine der bekannten Lösungen eine sichere Betriebsführung sowie eine hohe Sicherheit von Personen im Bereich der Gleichstrombahnen gewährleisten.

Die Aufgabe der Erfindung besteht darin, ein Verfahren und eine Vorrichtung anzugeben, mit denen die Überwachung elektrischer Leitungen und Verbindungen zur Feststellung der Betriebs- und Personensicherheit in Gleichrichterunterwerken und den zugehörigen Streckenabschnitten elektrischer Bahnen bei denen das Rückleitungssystem und das Erdungssystem geprüft werden, erfolgt.

Das erfindungsgemäße Verfahren zur Überwachung elektrischer Leitungen und Verbindungen in Gleichrichterunterwerken und den zugehörigen Streckenabschnitten elektrischer Bahnen wird charakterisiert durch die Merkmale des Patentanspruchs 1. Zur Feststellung der Betriebs- und Personensicherheit des elektrischen Stromkreises eines Streckenabschnittes von Gleichstrombahnen sowie der Kabelverbindungen in einem Gleichrichterunterwerk und den zugehörigen Streckenabschnitten wird nach Erstellung oder Revision des Gleichrichterunterwerks und oder den zugehörigen Streckenabschnitten an definierten Messpunkten ein definierter elektrischer Impuls in den zu überwachenden Stromkreis eingespeist. Dabei werden die jeweiligen Kurvenverläufe von Strom und Spannung als Referenzwerte aufgezeichnet und gespeichert. Diese Kurven sind charakteristisch für die Gesamtimpedanz des äußeren zu überwachenden Stromkreises zu einem Zeitpunkt, an dem sich die Anlage in einem einwandfreien Zustand befindet. Dies erfolgt beispielsweise unmittelbar nach der Errichtung bzw. einer Revision. In regelmäßigen Zeitabständen bzw. bei Verdacht einer Störung wird eine Vergleichsmessung durchgeführt. Dazu wird ein gleicher definierter elektrischer Impuls in die beiden definierten Messpunkte des zu überwachenden Stromkreises eingespeist und ebenfalls die jeweiligen Kurvenverläufe von Strom und Spannung aufgezeichnet Die nun gemessenen Kurvenverläufe werden mit den aufgezeichneten Referenzwerten verglichen. Bei Übereinstimmung der Kurvenverläufe bzw. bei Abweichungen, die innerhalb festgelegter Toleranzgrenzen liegen, weicht die Gesamtimpedanz des äußeren zu überwachenden Stromkreises kaum von der Gesamtimpedanz zum Zeitpunkt der Referenzmessung ab. Das bedeutet, dass die elektrischen Anlagenteile und deren Verbindungen in dem zu überwachenden Stromkreis in Ordnung sind. Weichen die Kurvenverläufe zu stark von den Referenzwerten ab und liegen außerhalb der festgelegten Toleranzgrenzen, ist von einer Störung im zu überwachenden Stromkreis auszugehen, deren Ursache gezielt zu ermitteln ist.

Die definierten Messpunkte können beispielsweise innerhalb des Gleichrichterunterwerkes einerseits das Rückleiteranschlusskabel, auch als Bahnerde bezeichnet, und andererseits die Bauwerkserde, auch als Wassererde bezeichnet, des Gleichrichterunterwerkes sein.

Weitere vorteilhafte Ausgestaltungen des erfindungsgemäßen Verfahrens können den abhängigen Patentansprüchen 2 bis 5 entnommen werden.

Die erfindungsgemäße Vorrichtung zur Durchführung des Verfahrens zur Überwachung elektrischer Leitungen und Verbindungen wird charakterisiert durch die Merkmale des Patentanspruchs 6. Die erfindungsgemäße Vorrichtung besteht aus einer Spannungsquelle, einem Schalter, einem Spannungsmessgerät, einem Strommessgerät sowie einer Mess- und Steuereinrichtung. Die Vorrichtung ist an die beiden definierten Messpunkte im Gleichrichterunterwerk angeschlossen und ist parallel zum äußeren zu überwachenden Stromkreis angeordnet. Die Vorrichtung ist eingerichtet den definierten elektrischen Impuls vom Energiespeicher in den zu überwachenden Stromkreis einzuspeisen und mittels des Strommessgerätes und des Spannungsmessgerätes Strom und Spannung zu messen und mittels der Mess- und Steuereinrichtung die Kurvenverläufe von Strom und Spannung als Referenzwerte zu ermitteln und zu speichern. Sie ist weiterhin derart eingerichtet die Kurvenverläufe von Strom und Spannung bei Vergleichsmessungen mit festgelegten Toleranzbändern von Strom und die Spannung zu vergleichen.

Die erfindungsgemäße Vorrichtung wird zur Überwachung eines Stromkreises verwendet, der durch die Bauwerkserde des Gleichrichterunterwerkes, das Erdreich, den Bettungswiderstand des Gleisbettes, die Gleise sowie das Rückleitungssystem gebildet wird und eine definierte Gesamtimpedanz aufweist. Dabei wird die Vorrichtung parallel zu dem überwachenden Stromkreis angeordnet und der erste Messpunkt wird direkt mit der Bauwerkserde des Gleichrichterunterwerkes verbunden und über das Erdreich und den Bettungswiderstand des Gleisbettes sowie die Gleise und das Rückleiteranschlusskabel wird der Stromkreis über den zweiten Messpunkt geschlossen.

Eine weitere Verwendung der Vorrichtung besteht darin, dass die Vorrichtung direkt mit einem Erdungskurzschließer kombiniert ist, indem der Erdungskurzschließer ebenfalls parallel zur Vorrichtung sowie dem zu überwachenden Stromkreis angeordnet und mit den beiden Messpunkten verbunden ist.

Die Vorteile des erfindungsgemäßen Verfahrens bestehen insbesondere darin, dass mit einfachen Mitteln gleichzeitig eine sichere Betriebsführung sowie eine hohe Sicherheit von Personen im Bereich der Gleichstrombahnen gewährleistet werden kann. Es kann auch auf fehlende Kabel bzw. Kabelverbindungen, z. B. durch Diebstahl oder Verschleiß geschlussfolgert werden. Mit dem vorgestellten Verfahren sowie der Vorrichtung können die unterschiedlichsten Stromkreise überprüft und überwacht werden. Da mit diesem Verfahren Kurvenverläufe von Strom und Spannung erfasst werden, die von der Gesamtimpedanz des zu überprüfenden Stromkreises abhängen, wird sich jede signifikante Änderung der Gesamtimpedanz durch eine signifikante Änderung der Kurvenverläufe von Strom und Spannung auswirken. Indem die jeweils gemessenen Kurven von Strom und Spannung mit den aufgezeichneten Referenzwerten verglichen werden, kann bei signifikanten Abweichungen zwischen Messwerten und Referenzwerten auf einen Fehler im zu überwachenden Stromkreis geschlossen werden.

Das erfindungsgemäße Verfahren zur Überwachung elektrischer Leitungen und Verbindungen in Gleichrichterunterwerken und den zugehörigen Streckenabschnitten elektrischer Bahnen, wird nachfolgend anhand eines Ausführungsbeispiels näher erläutert. Im gewählten Beispiel wird der Stromkreis in einem Streckenabschnitt einer Gleichstrombahn vom Gleichrichterunterwerk über die Stromschiene, die Rückleitung sowie Erdreich zurück zum Gleichrichterunterwerk überwacht bzw. überprüft.

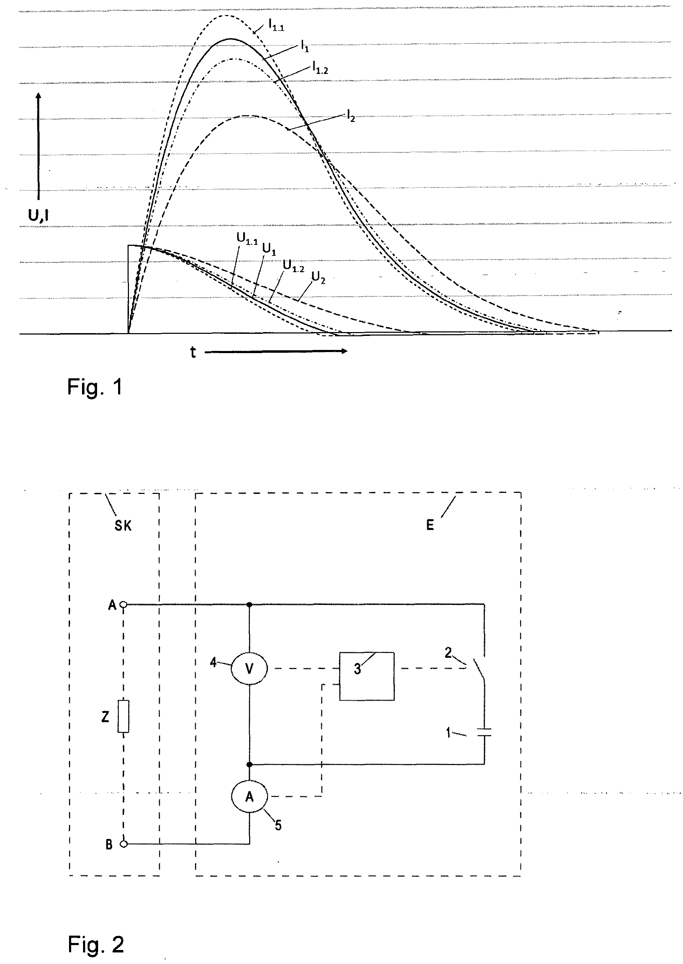

In der Fig. 1 sind die Kurven des Stromes I und der Spannung U dargestellt, die sich durch das Auslösen eines definierten elektrischen Impulses aus einer Energiequelle 1 bedingt durch die im äußeren Stromkreis wirkende Gesamtimpedanz Z ergeben. Der ausgelöste Impuls weist eine Spannung U sowie einen Strom I auf und hat eine Impulsdauer D von einigen Millisekunden. Die Messwerterfassung im Steuergerät erfolgt in einem Taktzyklus von ca. 50 Mikrosekunden.

Die Kurven des Stromes I und der Spannung U, die von dem Impuls erzeugt werden, werden vom Strommessgerät 5 sowie dem Spannungsmessgerät 4 ermittelt und von der Mess- und Steuereinrichtung 3 ausgewertet und gespeichert. Die Referenzkurven des Stromes I₁ und der Spannung U₁ sind von der Mess- und Steuereinrichtung 3 zu einem Zeitpunkt aufgezeichnet worden, an dem sich alle Anlagenteile des äußeren Stromkreises mit der Gesamtimpedanz Z in einem einwandfreien Zustand befanden. Da sich die Gesamtimpedanz Z, die auch vom Bettungswiderstand RB und damit wiederum von meteorologischen Bedingungen abhängt, auch ohne Vorliegen einer Störung ändern kann, wird ein Toleranzband für den Strom- und den Spannungsverlauf festgelegt. Das Toleranzband für den Stromverlauf wird durch die beiden Kurven I_{1.1} und I_{1.2} begrenzt. Die Kurven U_{1.1} und U_{1.2} begrenzen ihrerseits das Toleranzband für den Spannungsverlauf.

In der Fig. 1 sind weiterhin die aktuellen Kurven des Stromes I und der Spannung U dargestellt, die vom Strommessgerät 5 sowie dem Spannungsmessgerät 4 ermittelt und von der Mess- und Steuereinrichtung 3 zu einem späteren Zeitpunkt bei einer durchgeführten Vergleichsmessung aufgezeichnet wurden. Der Verlauf der Kurve für den Stromverlauf I₂, die hier deutlich flacher ausfällt, deutet darauf hin, dass die Gesamtimpedanz Z im äußeren zu überwachenden Stromkreis jetzt größer als zum Zeitpunkt der Referenzmessung ist. Der jetzt gemessene Stromimpuls ist geringer als bei der Referenzmessung und durch den geringeren Strom I₂ wird sich die Spannung U₂ des Energiespeichers 1 über einen längeren Zeitraum abbauen. Die jetzt gemessenen Strom- und Spannungsverläufe I₂, U₂ liegen außerhalb der festgelegten Toleranzbänder für Strom I_{1.1} und I_{1.2} und Spannung U_{1.1} und U_{1.2} und lassen darauf schließen, dass Anlagenteile bzw. Verbindungen nicht den projektierten Werten entsprechen und die Fehlerstellen ermittelt werden müssen.

In der Fig. 2 ist eine Vorrichtung E schematisch dargestellt. Die Vorrichtung E wird an die beiden Messpunkte A und B des zu überwachenden äußeren Stromkreises angeschlossen, um die elektrischen Parameter, die der Gesamtimpedanz Z entsprechen, zu ermitteln. Der zu überwachende äußere Stromkreis SK wird im gewählten Beispiel durch die Bauwerkserde BWE des Gleichrichterunterwerkes, das Erdreich ER, den Bettungswiderstand des Gleisbettes RB, die Gleise G sowie das Rückleitungssystem gebildet. Die Vorrichtung E ist parallel zum zu überwachenden äußeren Stromkreis SK angeordnet und wird gebildet aus einer Spannungsquelle, die im gewählten Beispiel aus einem Energiespeicher 1 besteht, einem Schalter 2, einer Mess- und Steuereinrichtung 3 sowie einem Spannungsmessgerät 4 und einem Strommessgerät 5. Dabei ist das Strommessgerät 5 in Reihe mit dem Energiespeicher 1 und dem Schalter 2 angeordnet, während das Spannungsmessgerät 4 parallel hierzu angeordnet ist. Durch die Mess- und Steuereinrichtung 3 wird die Messung dadurch ausgelöst, dass der Schalter 2 einen Energieimpuls aus der Energiequelle 1 auslöst, der sich durch den zu überwachenden äußeren Stromkreis eines Streckenabschnittes einer Gleichstrombahn vom Messpunkt A zum Messpunkt B ausbreitet. Die Kapazität des Energiespeichers 1 zur Erzeugung des Impulses, der die Spannung U und den Strom I aufweist und eine Impulsdauer D hat, wird entsprechend der Gesamtimpedanz Z des zu überwachenden Stromkreises SK derart gewählt, dass die Messgrößen zu auswertbaren Verläufen von Strom I₁, I₂ und Spannung U₁, U₂ führen. Zwischen den beiden Messpunkten A und B wird mit dem Spannungsmessgerät 4 der Spannungsverlauf und mit dem Strommessgerät 5 der Stromverlauf ermittelt und in der Mess- und Steuereinrichtung 3 ausgewertet und gespeichert. In Abhängigkeit von den elektrischen Parametern in diesem äußeren Stromkreis ergeben sich charakteristische Kurven für den Spannungs- und den Stromverlauf.

Die von der Mess- und Steuereinrichtung 3 aufgezeichneten Kurven des Stromes I₁ und der Spannung U₁, die zu einem Zeitpunkt aufgezeichnet wurden, an dem sich alle Anlagenteile des äußeren Stromkreises mit der Gesamtimpedanz Z in einem einwandfreien Zustand befanden, werden als Referenzwerte in der Mess- und Steuereinrichtung 3 gespeichert. Da sich die Gesamtimpedanz Z, die auch vom Bettungswiderstand RB abhängt, also auch von meteorologischen Verhältnissen beeinflusst wird, kann sich die Gesamtimpedanz ändern ohne dass eine Störung im zu prüfenden Stromkreis vorliegt. Deshalb werden Toleranzbänder für den Strom- und den Spannungsverlauf festgelegt und im Steuergerät 3 hinterlegt. Das Toleranzband für den Stromverlauf wird durch die beiden Kurven I_{1.1} und I_{1.2} begrenzt. Das Toleranzband für den Spannungsverlauf wird durch die beiden Kurven U_{1.1} und U_{1.2} begrenzt. Die zu einem beliebigen späteren Zeitpunkt ermittelten Strom- und Spannungsverläufe I₂, U₂ werden in der Mess- und Steuereinrichtung 3 mit den hinterlegten Toleranzbändern für die Spannung U_{1.1} und U_{1.2} sowie den Strom I_{1.1} und I_{1.2} verglichen. Die jetzt gemessenen Strom- und Spannungsverläufe I₂, U₂ liegen im gewählten Beispiel außerhalb der festgelegten Toleranzbänder für Strom I_{1.1} und I_{1.2} und Spannung U_{1.1} und U_{1.2} und lassen darauf schließen, dass Anlagenteile bzw. Verbindungen nicht den projektierten Werten entsprechen und die Fehlerstellen ermittelt werden müssen.

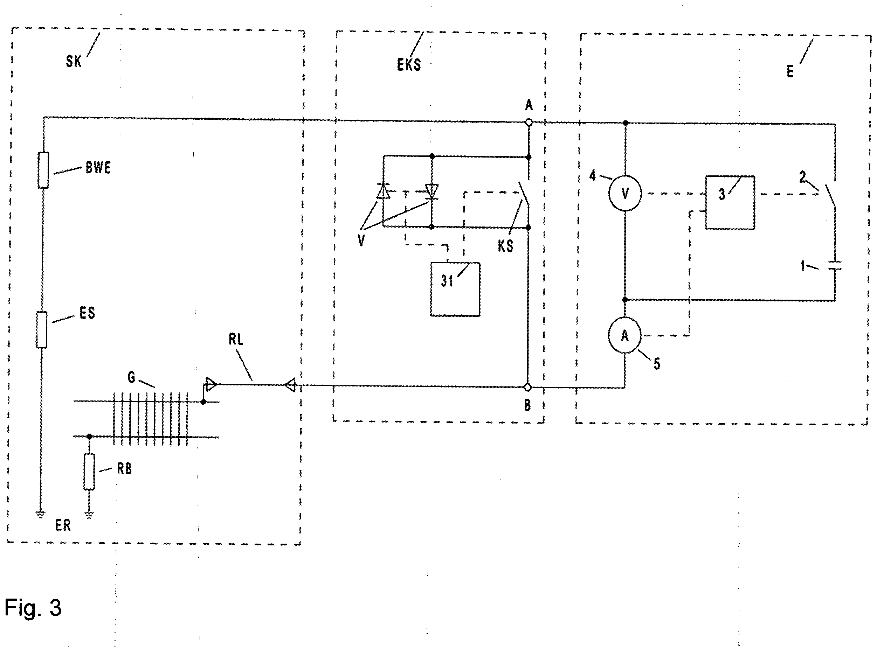

In der Fig. 3 ist die Verwendung der Vorrichtung in einem Gleichrichterunterwerk mit seinem Rückleitungs- und Erdungssystem dargestellt, wobei die Vorrichtung E mit einem Erdungskurzschließer EKS kombiniert wird. Der äußere zu überwachende Stromkreis SK, der durch die Gesamtimpedanz Z abgebildet ist, wird einerseits an den Messpunkt A angeschlossen, der direkt mit dem Erdungssystem ES des Gleichrichterunterwerkes über die Bauwerkserde BWE verbunden ist. Der Strom fließt durch das Erdreich ER und den Bettungswiderstand des Gleisbettes RB sowie die Gleise G über die Rückleiteranschlusskabel RL zum zweiten Messpunkt B, der andererseits auch mit der Vorrichtung E verbunden ist, wodurch der äußere Stromkreis SK geschlossen wird. Der Erdungskurzschließer EKS ist parallel zur Vorrichtung E ebenfalls zwischen den beiden Messpunkten A und B angeordnet.

Der Erdungskurzschließer EKS ist eine Spannungsbegrenzungseinrichtung nach DIN EN 50526 2:2014 07. Er hat die Aufgabe, unzulässig hohe Potenzialdifferenzen zwischen den Punkten A und B durch Herstellung einer elektrischen Verbindung zwischen diesen beiden Punkten abzubauen. Hierzu wird durch die Steuereinrichtung im Erdungskurzschließer 31 kontinuierlich die Spannung zwischen den Punkten A und B gemessen. Entsprechend einer hinterlegten Spannungs-Zeit-Kennlinie werden bei Überschreitung festgelegter Werte die Halbleiterventile V und das Schütz KS eingeschaltet. Die Halbleiterventile V dienen zum Erreichen der gegebenenfalls geforderten sehr kurzen Einschaltzeiten, das Schütz KS führt die Ausgleichsströme während der Verbindung zwischen den Punkten A und B. Zweckmäßigerweise kann die Steuereinrichtung 31 des EKS mit der Mess- und Steuereinrichtung 3 der Vorrichtung E als gemeinsames Bauteil ausgeführt werden.

### Aufstellung der verwendeten Bezugszeichen:

- 1: Energiespeicher
- 2: Schalter
- 3: Mess- und Steuereinrichtung
- 4: Spannungsmessgerät
- 5: Strommessgerät
- 5.1: Messwiderstand
- E: Vorrichtung zur Überwachung eines Stromkreises
- A: Erster Messpunkt (im zu überwachenden Stromkreis)
- B: Zweiter Messpunkt (im zu überwachenden Stromkreis)
- Z: Gesamtimpedanz des zu überwachenden Stromkreises
- BWE: Bauwerkserde
- ER: Erdreich
- RB: Bettungswiderstand des Gleisbettes
- G: Gleise
- RL: Rückleiteranschlusskabel
- EKS: Erdungskurzschliesser
- SK: zu überwachender Stromkreis
- U: Spannung
- U1: Kurvenverlauf der Referenzspannung
- U1.1, U1.2: Kurvenverläufe des Toleranzbandes für die Referenzspannung
- U2: Kurvenverlauf der Spannung der Vergleichsmessung
- I: Strom
- I1: Kurvenverlauf des Referenzstromes
- I1.2, I1.2: Kurvenverläufe des Toleranzbandes für den Referenzstrom
- I2: Kurvenverlauf des Stromes der Vergleichsmessung
- D: Impulsdauer
- V: Halbleiterventile im Erdungskurzschließer
- KS: Schütz im Erdungskurzschließer
- 31: Steuereinrichtung im Erdungskurzschließer

## Patentansprüche

1. Verfahren zur Überwachung elektrischer Leitungen und Verbindungen zur Feststellung der Betriebs- und Personensicherheit in Gleichrichter-Unterwerken und den zugehörigen Streckenabschnitten elektrischer Bahnen bei dem das Rückleitungssystem und das Erdungssystem geprüft werden,
**dadurch gekennzeichnet, dass**
nach Erstellung bzw. Revision des Gleichrichter-Unterwerks an definierten Messpunkten (A, B) des Gleichrichter-Unterwerks ein definierter elektrischer Impuls mit einer Spannung (U) und einem Strom (I) sowie einer Impulsdauer (D) in einen zu überwachenden Stromkreis (SK) mit der Gesamtimpedanz (Z) eingespeist wird und die Verläufe von Strom (I₁) und Spannung (U₁) als Referenzwerte aufgezeichnet und gespeichert werden, die mit den Verläufen von Strom (I₂) und Spannung (U₂) einer Vergleichsmessung verglichen werden wobei für die Verläufe von Strom (I₁) und Spannung (U₁) Toleranzbänder für den Strom (I_{1.1}, I_{1.2}) und die Spannung (U_{1.1}, U_{1.2}) festgelegt werden und aus Verläufen von Strom (I₂) und Spannung (U₂), die bei Vergleichsmessungen innerhalb des Toleranzbandes (I_{1.1}, I_{1.2}, U_{1.1}, U_{1.2}) liegen, auf ein intaktes Rückleitungs- und Erdungssystem geschlossen werden kann.

2. Verfahren nach Anspruch 1,
**dadurch gekennzeichnet, dass**
Vergleichsmessungen in regelmäßigen Zeitabständen oder bei Verdacht einer Störung mit dem gleichen elektrischen Impuls mit der Spannung (U) und dem Strom (I) sowie der Impulsdauer (D) durchgeführt werden.

3. Verfahren nach Anspruch 1,
**dadurch gekennzeichnet, dass**
die Größe des Impulses, mit der Spannung (U), dem Strom (I) und der Impulsdauer (D), entsprechend der Gesamtimpedanz (Z) des zu überwachenden Stromkreises (SK) derart gewählt wird, dass ein Strommessgerät (4) und ein Spannungsmessgerät (5) Werte von Strom (I₁, I₂) und Spannung (U₁, U₂) erfassen, die in einer Mess- und Steuereinrichtung (3) zu auswertbaren Verläufen von Strom (I₁, I₂) und Spannung (U₁, U₂) verarbeitet und gespeichert werden.

4. Verfahren nach Anspruch 1,
**dadurch gekennzeichnet, dass**
die Impulsdauer (D) des elektrischen Impulses im Bereich von einigen Millisekunden liegt.

5. Verfahren nach Anspruch 1,
**dadurch gekennzeichnet, dass**
die Taktfrequenz der Messungen zur Aufzeichnung der Kurvenverläufe von Strom (I₁, I₂) und Spannung (U₁, U₂) im Bereich von ca. 50 Mikrosekunden liegt.

6. Vorrichtung zur Überwachung elektrischer Leitungen und Verbindungen zur Feststellung der Betriebs- und Personensicherheit in Gleichrichter-Unterwerken und den zugehörigen Streckenabschnitten elektrischer Bahnen zur Durchführung des Verfahrens nach Anspruch 1, die einen Energiespeicher (1), einen Schalter (2), eine Mess- und Steuereinrichtung (3) sowie ein Strommessgerät (4) aufweist und im Gleichrichter-Unterwerk an zwei definierten Messpunkten (A, B) an den zu überwachenden Stromkreis (SK) angeschlossen ist,
**dadurch gekennzeichnet, dass**
die Vorrichtung (E) außerdem ein Spannungsmessgerät (5) aufweist und die Vorrichtung (E) so eingerichtet ist einen elektrischen Impuls vom Energiespeicher (1) in den zu überwachenden Stromkreis (SK) einzuspeisen und mittels des Strommessgerätes (4) und des Spannungsmessgerätes (5) Strom (I₁, I₂) und Spannung (U₁, U₂) zu messen und mittels der Mess- und Steuereinrichtung (3) die Kurvenverläufe von Strom (I₁, I₂) und Spannung (U₁, U₂) als Referenzwerte zu ermitteln und zu speichern und mit Kurvenverläufen bei Vergleichsmessungen mit festgelegten Toleranzbändern von Strom (I_{1.1}, I_{1.2}) und Spannung (U_{1.1}, U_{1.2}) zu vergleichen.

7. Verwendung der Vorrichtung nach Anspruch 6 zur Überwachung eines Stromkreises (SK), der eine Gesamtimpedanz (Z) aufweist
**dadurch gekennzeichnet, dass**
der zu überwachende Stromkreis (SK), durch die Bauwerkserde (BWE) des Gleichrichterunterwerkes, das Erdreich, den Bettungswiderstand des Gleisbettes (RB), die Gleise sowie das Rückleitungssystem gebildet wird.

8. Verwendung der Vorrichtung nach Anspruch 6 zur Überwachung eines Stromkreises (SK),
**dadurch gekennzeichnet, dass**
die Vorrichtung (E) parallel zu dem überwachenden Stromkreis angeordnet ist wobei der erste Messpunkt (A) direkt mit der Bauwerkserde (BWE) des Gleichrichterunterwerkes verbunden ist und über das Erdreich und den Bettungswiderstand des Gleisbettes (RB) sowie die Gleise und das Rückleiteranschlusskabel (RL) mit dem zweiten Messpunkt (B) verbunden ist.

9. Verwendung der Vorrichtung nach Anspruch 6 zur Überwachung eines Stromkreises (SK),
**dadurch gekennzeichnet, dass**
die Vorrichtung (E) direkt mit einem Erdungskurzschließer (EKS) kombiniert ist, indem der Erdungskurzschließer (EKS) ebenfalls parallel zur Vorrichtung (E) sowie dem zu überwachenden Stromkreis angeordnet und mit den beiden Messpunkten (A, B) verbunden ist.

## Claims

1. Method for monitoring electrical lines and compounds for determining operational and personal safety in rectifier sub-stations and associated routes of electrical railways where the return system and the earthing system are checked,
**characterized in that**,
after creation and revision of the rectifier sub-station at defined measuring points (A, B) of the rectifier sub-station, a defined electrical pulse with a voltage (U) and a current (I), as well as a pulse duration (d) is fed into a circuit (SK) with a total impedance (Z) and the progressions of current (I₁) and voltage (U₁) are recorded and saved as reference values, which are compared with the progressions of current (I₂) and voltage (U₂) of a comparative measurement, wherein, for the progressions of current (I₁) and voltage (U₁), tolerance ranges for the current (I_{1.1}, I_{1.2}) and the voltage (U_{1.1}, U_{1.2}) are determined, and an intact return and earthing system can be inferred from the progressions of current (I₂) and voltage (U₂), which are within the tolerance range (I_{1.1}, I_{1.2}, U_{1.1}, U_{1.2}) in comparative measurements.

2. Method according to Claim 1,
**characterized in that**
comparative measurements are carried out at regular intervals or, in case of suspicion of a fault, they are carried out with the same electrical pulse with the voltage (U) and the current (I), as well as the pulse duration (D).

3. Method according to Claim 1,
**characterized in that**
the level of the pulse, with the voltage (U), the current (I) and the pulse duration (D), is selected according to the total impedance (Z) of the circuit (SK) to be monitored in such a way that a current measuring device (4) and a voltage measuring device (5) detect values of current (I₁, I₂) and voltage (U₁, U₂), which are processed into evaluable progressions of current (I₁, I₂) and voltage (U₁, U₂) and stored in a measuring and control device (3).

4. Method according to Claim 1,
**characterized in that**
the pulse duration (D) of the electrical pulse is within a range of several milliseconds to approx. 10 milliseconds.

5. Method according to Claim 1,
**characterized in that**
the cycle frequency of the measurements for recording the curve progressions of current (I₁, I₂) and voltage (U₁, U₂) is at a range of approx. 50 microseconds.

6. Apparatus for the monitoring of electrical lines and compounds for determining the of operational and personal safety in rectifier sub-stations and the associated routes of electrical railways for carrying out the method according to Claim 1, which has an energy store (1), a switch (2), a measuring and control device (3) and a current measuring device (4), and is connected to the circuit (SK) to be monitored in the rectifier sub-station at two defined measuring points (A, B),
**characterized in that**
the apparatus (E) also has a voltage measuring device (5) and the apparatus (E) is set up in such a way as to feed an electric pulse from the energy store (1) into the circuit (SK) to be monitored and to measure current (I₁, I₂) and voltage (U₁, U₂) by means of the current measuring device (4) and the voltage measuring device (5), and to determine and store the curve progressions of current (I₁, I₂) and voltage (U₁, U₂) as reference values by means of the measuring and control device (3), and to compare them with curve progressions for comparative measurements with defined tolerance ranges of current (I_{1.1}, I_{1.2}) and voltage (U_{1.1}, U_{1.2}).

7. Use of the apparatus according to Claim 6 for monitoring a circuit (SK), which has a total impedance (Z),
**characterized in that**
the circuit to be monitored (SK) is formed by the structure ground (BWE) of the rectifier sub-station, the soil, the bedding resistance of the track bed (RB), the tracks as well as the return system.

8. Use of the apparatus according to Claim 6 for monitoring a circuit (SK),
**characterized in that**
the apparatus (E) is arranged in parallel to the circuit to be monitored, wherein the first measuring point (A) is connected directly to the structure ground (BWE) of the rectifier sub-structure and is connected to the second measuring point (B) via the soil and the bed resistance of the track bed (RB), as well as the tracks and the return connection cable (RL).

9. Use of the apparatus according to Claim 6 for monitoring a circuit (SK),
**characterized in that**
the apparatus (E) is combined directly with an earthing switch (EKS) by the earthing switch (EKS) also being arranged in parallel to the apparatus (E) as well as the circuit to be monitored and being connected to the two measuring points (A, B).

## Revendications

1. Procédé de surveillance des conducteurs électriques et des raccordements destinés à la constatation de la sécurité de fonctionnement et des personnes dans des sous-stations à redresseur et des sections de route des voies électriques associées pour lequel le système de retour et le système de mise à la terre sont vérifiés,
**caractérisé en ce qu'**
après établissement ou révision de la sous-station à redresseur aux points de mesures définis (A, B) de la sous-station à redresseur, une impulsion électrique définie avec une tension (U) et un courant (I) ainsi qu'une durée d'impulsion (D) est acheminée dans un circuit de courant (SK) à surveiller avec l'impédance totale (Z) et les profils du courant (I₁) et de tension (U₁) sont enregistrés et mémorisés en tant que valeurs de référence, qui sont comparés aux profils du courant (I₂) et de la tension (U₂) d'une mesure de comparaison, sachant que pour les profils du courant (I₁) et de la tension (U₁) des bandes de tolérances sont fixées pour le courant (I_{1.1},I_{1.2}) et la tension (U_{1.1}, U_{1.2}) et qu'à partir des profils de courant (I₂) et de tension (U₂), qui se situent à l'intérieur de la bande de tolérances (I_{1.1}, I_{1.2}, U_{1.1}, U_{1.2}) lors des mesures de comparaison, on peut conclure à un système de retour et de mise à la terre intact.

2. Procédé selon la revendication 1,
**caractérisé en ce que**
des mesures de comparaison sont effectuées à des intervalles de temps réguliers ou en cas de doute d'une anomalie avec la même impulsion électrique avec la tension (U) et le courant (I) ainsi que la durée d'impulsion (D).

3. Procédé selon la revendication 1,
**caractérisé en ce que**
la taille de l'impulsion est choisie avec la tension (U), le courant (I) et la durée d'impulsion (D), selon l'impédance totale (Z) du circuit de courant (SK) à surveiller de telle manière qu'un ampèremètre (4) et un tensiomètre (5) saisissent les valeurs du courant (I₁, I₂) et de la tension (U₁, U₂), qui sont traitées et mémorisées dans un dispositif de mesure et de commande (3) pour les profils exploitables du courant (I₁, I₂) et de la tension (U₁, U₂).

4. Procédé selon la revendication 1,
**caractérisé en ce que**
la durée d'impulsion (D) de l'impulsion électrique se situe dans la gamme de plusieurs millisecondes à env. 10 millisecondes.

5. Procédé selon la revendication 1,
**caractérisé en ce que**
la fréquence de rythme des mesures pour l'enregistrement des profils de courbe du courant (I₁, I₂) et de la tension (U₁, U₂) se situe dans la gamme d'env. 50 microsecondes.

6. Dispositif de surveillance des conducteurs électriques et des raccordements destinés à la constatation de la sécurité de fonctionnement et des personnes dans des sous-stations à redresseur et des sections de route des voies électriques associées pour l'exécution du procédé selon la revendication 1, qui comporte un accumulateur d'énergie (1), un interrupteur (2), un dispositif de mesure et de commande (3) ainsi qu'un ampèremètre (4) et est raccordé dans la sous-station à redresseur à deux points de mesure définis (A, B) sur le circuit de courant à surveiller (SK),
**caractérisé en ce que**
le dispositif (E) comporte en outre un tensiomètre (5) et le dispositif (E) est agencé de manière à injecter une impulsion électrique de l'accumulateur d'énergie (1) dans le circuit de courant (SK) à surveiller et à mesurer le courant (I₁, I₂) et la tension (U₁, U₂) au moyen de l'ampèremètre (4) et du tensiomètre (5) et à déterminer et mémoriser les profils de courbe du courant (I₁, I₂) et de la tension (U₁, U₂) en tant que valeurs de référence au moyen du dispositif de mesure et de commande (3) et à les comparer aux profils de courbe lors des mesures de comparaison avec des bandes de tolérances définies du courant (I_{1.1}, I_{1.2}) et de la tension (U_{1.1}, U_{1.2}).

7. Utilisation du dispositif selon la revendication 6 pour la surveillance d'un circuit de courant (SK), qui comporte une impédance totale (Z),
**caractérisé en ce que**
le circuit de courant à surveiller (SK), est formé par les mises à la terre de l'ouvrage (BWE) de la sous-station à redresseur, la terre, la résistance du ballast de la couche de forme (RB), les voies ainsi que par le système de retour.

8. Utilisation du dispositif selon la revendication 6 pour la surveillance d'un circuit de courant (SK),
**caractérisé en ce que**
le dispositif (E) est disposé parallèle au circuit de courant à surveiller, sachant que le premier point de mesure (A) est directement relié à la mise à la terre de l'ouvrage (BWE) de la sous-station à redresseur et est relié au deuxième point de mesure (B) par la terre et la résistance du ballast de la couche de forme (RB) ainsi que les voies et le câble de connexion de retour (RL).

9. Utilisation du dispositif selon la revendication 6 pour la surveillance d'un circuit de courant (SK),
**caractérisé en ce que**
le dispositif (E) est directement combiné à un court-circuiteur de mise à la terre (EKS) dans lequel le court-circuiteur de mise à la terre (EKS) est disposé également parallèle au dispositif (E) ainsi qu'au circuit de courant à surveiller et est relié aux deux points de mesure (A, B).
